# EUROPEAN PATENT APPLICATION

(11) **EP 4 692 820 A1**
(43) Date of publication of application: **11.02.2026**
(21) Application number: 23929773.2
(22) Date of filing: 14.08.2023
(51) Int. Cl.: G01R 31/371, G01R 31/396, G01R 31/385, G01R 31/36, H04W 4/30, H04W 76/11, H04L 61/50

(54) **OFF-THE-PRODUCTION-LINE TEST METHOD, APPARATUS AND SYSTEM SUITABLE FOR WIRELESS COMMUNICATION BMS**

(30) Priority: 31.03.2023 CN 202310369428
(71) Applicant: Sungiant Automotive Electronics Co., Ltd., Shenzhen, Guangdong 518101 (CN)
(72) Inventor: XU, Tonghui, Shenzhen, Guangdong 518132 (CN); ZHUO, Hao, Shenzhen, Guangdong 518132 (CN)
(74) Representative: Meyer, Thorsten
(86) International application number: PCT/CN2023/112857
(87) International publication number: WO 2024/198197

(57) **Abstract**

The present disclosure provides an off-the-production-line test method, apparatus, and system for a wireless communication battery management system (BMS). The method includes: sending first analog signals in a one-to-one correspondence with a plurality of electronic information acquisition units of a BMS to the plurality of electronic information acquisition units through physical connection lines such that the plurality of electronic information acquisition units generate respective first address information; sending addressing information to the plurality of electronic information acquisition units, and establishing wireless communication with the plurality of electronic information acquisition units after the plurality of electronic information acquisition units respond to the addressing information; and receiving to-be-tested battery information uploaded by the plurality of electronic information acquisition units, and determining the electronic information acquisition unit corresponding to each piece of to-be-tested battery information based on the respective first address information of the plurality of electronic information acquisition units. Through the apparatus in the embodiments of the present disclosure, the electronic information acquisition unit establishes wireless communication with the test apparatus through unique first address information, to prevent crosstalk problems that a position of the electronic information acquisition unit cannot be determined and a source of the to-be-tested battery information cannot be distinguished.

## Description

### TECHNICAL FIELD

The present disclosure relates to the technical field of battery management system (BMS) testing, and in particular, to an off-the-production-line test method, apparatus, and system for a wireless communication BMS.

### BACKGROUND

With vigorous development of electric vehicles in the new energy field, harnesses used for communication in new energy vehicles are becoming increasingly numerous and complex. Consequently, issues stemming from harness connections are also on the rise. A solution in which a plurality of electronic control units are connected through wireless communication is gaining growing favor among new energy vehicle manufacturers. There is also increasing advocacy among vehicle manufacturers for using a wireless communication solution in a BMS of a new energy vehicle. If the BMS uses wireless communication, it no longer relies on a fixed physical address of each electronic control unit inherent in wired communication, where each electronic control unit can be distinguished through a harness. During an off-the-production-line test, if a plurality of electronic control units are simultaneously measured and monitored, a wireless communication test bench cannot identify a currently tested wireless communication electronic control unit and thus cannot accurately establish a unique connection to the currently tested wireless communication electronic control unit. Consequently, there are various connections between a plurality of wireless communication test benches and a plurality of wireless communication electronic control units, making it impossible to identify a position of the currently tested wireless communication electronic control unit and distinguish the specific wireless communication electronic control unit. This results in a high wireless communication test failure rate or bit error rate, which directly reduces an off-the-production-line test passing rate and production efficiency of wireless communication electronic control units.

### SUMMARY

The present disclosure provides an off-the-production-line test method, apparatus, and system for a wireless communication BMS, to resolve a technical problem in the prior art that test data cannot correspond to an electronic information acquisition unit when a wireless communication connection is used for production testing of a BMS.

To resolve the foregoing technical problem, the embodiments of the present disclosure provide an off-the-production-line test method for a wireless communication BMS, including:
respectively sending first analog signals in a one-to-one correspondence with a plurality of electronic information acquisition units to the plurality of electronic information acquisition units such that the plurality of electronic information acquisition units generate respective first address information based on the respectively received first analog signals;
sending addressing information to the plurality of electronic information acquisition units, and establishing wireless communication with the plurality of electronic information acquisition units that respond to the addressing information such that the plurality of electronic information acquisition units upload to-be-tested battery information that carries the respective first address information; and
receiving, through wireless communication, the to-be-tested battery information uploaded by the plurality of electronic information acquisition units, and determining the electronic information acquisition unit corresponding to each piece of to-be-tested battery information based on the respective first address information of the plurality of electronic information acquisition units.

In the present disclosure, the corresponding first analog signals are sent to the electronic information acquisition units through hardware connections. Different electronic information acquisition units establish different first address information based on different first analog signals. In this way, each electronic information acquisition unit establishes wireless communication with the test apparatus through its unique first address information, and sends the to-be-tested battery information through wireless communication to complete testing. This prevents crosstalk problems that a position of the electronic information acquisition unit cannot be determined and a source of the to-be-tested battery information cannot be distinguished when the test apparatus tests a plurality of electronic information acquisition units.

Further, the respectively sending first analog signals in a one-to-one correspondence with a plurality of electronic information acquisition units to the plurality of electronic information acquisition units is specifically as follows:
fixedly connecting a test fixture to the plurality of electronic information acquisition units; and
correspondingly setting different levels for different electronic information acquisition units, and sending the corresponding first analog signal to each electronic information acquisition unit based on the level corresponding to each electronic information acquisition unit.

In the present disclosure, fixed physical connections to different electronic information acquisition units are implemented through the test fixture, and different first analog signals are sent to different electronic information acquisition units through level setting such that the electronic information acquisition units establish the respective first address information based on the first analog signals, to identify data sources and determine positions of the electronic information acquisition units during test data transmission.

Further, the correspondingly setting different levels for different electronic information acquisition units is specifically as follows:
adjusting a resistance of an output pull-up resistor such that the output pull-up resistor and an input pull-down resistor of each electronic information acquisition unit connected to the output pull-up resistor are combined to obtain a corresponding level.

In the present disclosure, the first analog signal input to the electronic information acquisition unit is changed through the combination of the output pull-up resistor and the input pull-down resistor such that different first analog signals are input to different electronic information acquisition units, to establish mutually distinguishable first address information.

Further, the sending the corresponding first analog signal to each electronic information acquisition unit based on the level corresponding to each electronic information acquisition unit is specifically as follows:
converting a rated working voltage into the plurality of first analog signals with different voltages based on the level corresponding to each electronic information acquisition unit; and
respectively sending the corresponding first analog signals for the corresponding levels to the plurality of electronic information acquisition units based on a preset sending sequence.

In the present disclosure, different levels are set to convert the working voltage into the first analog signals with different voltages.

Further, the plurality of electronic information acquisition units generate the respective first address information is specifically as follows:
the plurality of electronic information acquisition units identify voltages of the respectively received first analog signals, and establish the first address information corresponding to the respectively received first analog signals based on the identified voltages.

Further, after establishing the first address information corresponding to the respectively received first analog signals, the method includes:
respectively storing, by the electronic information acquisition units, the first address information of the electronic information acquisition units; and
when the voltage of the first analog signal received by an electronic information acquisition unit is 0 V, clearing the first address information stored by the electronic information acquisition unit.

In the present disclosure, the electronic information acquisition units establish mutually different first address information based on the received first analog signals, to prevent crosstalk during wireless communication connections to a test device or the test apparatus.

Further, when respectively sending the first analog signals in a one-to-one correspondence with the plurality of electronic information acquisition units to the plurality of electronic information acquisition units, the method further includes:
receiving a second analog signal from a test fixture or a computer terminal, and identifying a voltage of the second analog signal; and
establishing unique second address information based on the voltage of the second analog signal, and sending wireless operation instructions that contain the second address information to the plurality of electronic information acquisition units.

In the present disclosure, when electronic information acquisition modules perform addressing, the test apparatus or the test device also performs addressing based on the second analog signal such that its second address information is distinguished from address information of another test apparatus, to prevent crosstalk when a plurality of test apparatuses are simultaneously used.

Further, after receiving, through wireless communication, the to-be-tested battery information uploaded by the plurality of electronic information acquisition units, and determining the electronic information acquisition unit corresponding to each piece of to-be-tested battery information based on the respective first address information of the plurality of electronic information acquisition units, the method includes:
where the to-be-tested battery information includes battery cell voltage information and battery cell temperature information;
performing data comparison on the battery cell voltage information and the battery cell temperature information based on actual operating parameters of a battery cell, determining whether the electronic information acquisition unit corresponding to the to-be-tested battery information is abnormal, and uploading a determining result obtained through the data comparison to a cloud manufacturing execution system (MES) of a production department.

According to another aspect, the embodiments of the present disclosure further provide an off-the-production-line test apparatus for a wireless communication BMS, including: an address establishment module, a communication establishment module, and a test data acquisition module.

The address establishment module is configured to respectively send first analog signals in a one-to-one correspondence with a plurality of electronic information acquisition units to the plurality of electronic information acquisition units, such that the plurality of electronic information acquisition units generate respective first address information based on the respectively received first analog signals.

The communication establishment module is configured to send addressing information to the plurality of electronic information acquisition units, and establish wireless communication with the plurality of electronic information acquisition units that respond to the addressing information such that the plurality of electronic information acquisition units upload to-be-tested battery information that carries the respective first address information.

The test data acquisition module is configured to receive, through wireless communication, the to-be-tested battery information uploaded by the plurality of electronic information acquisition units, and determine the electronic information acquisition unit corresponding to each piece of to-be-tested battery information based on the respective first address information of the plurality of electronic information acquisition units.

In the present disclosure, the corresponding first analog signals are sent to the electronic information acquisition units through hardware connections. Different electronic information acquisition units establish different first address information based on different first analog signals. In this way, each electronic information acquisition unit establishes wireless communication with the test apparatus through its unique first address information, and sends the to-be-tested battery information through wireless communication to complete testing. This prevents crosstalk problems that a position of the electronic information acquisition unit cannot be determined and a source of the to-be-tested battery information cannot be distinguished when the test apparatus tests a plurality of electronic information acquisition units.

According to another aspect, the embodiments of the present disclosure further provide an off-the-production-line test system for a wireless communication BMS, including: an off-the-production-line test device and a plurality of electronic information acquisition units.

The off-the-production-line test device is configured to perform the off-the-production-line test method for a wireless communication BMS according to any one of the embodiments of the present disclosure. The off-the-production-line test device includes a communication enabling module configured to send first analog signals to the plurality of electronic information acquisition units and receive first address information uploaded by the plurality of electronic information acquisition units.

The plurality of electronic information acquisition units are configured to generate the first address information corresponding to the respectively received first analog signals after receiving the first analog signals in a one-to-one correspondence with the plurality of electronic information acquisition units, establish wireless communication connections to the off-the-production-line test device in response to addressing information from the off-the-production-line test device, acquire to-be-tested battery information, and upload the to-be-tested battery information to the off-the-production-line test device through wireless communication. The electronic information acquisition unit includes an address detection module configured to identify a voltage of the first analog signal and generate first address information corresponding to the voltage of the first analog signal during an off-the-production-line test.

In the present disclosure, the corresponding first analog signals are sent to the electronic information acquisition units through hardware connections. Different electronic information acquisition units establish different first address information based on different first analog signals. In this way, each electronic information acquisition unit establishes wireless communication with the test apparatus through its unique first address information, and sends the to-be-tested battery information through wireless communication to complete testing. This prevents crosstalk problems that a position of the electronic information acquisition unit cannot be determined and a source of the to-be-tested battery information cannot be distinguished when the test apparatus tests a plurality of electronic information acquisition units.

### BRIEF DESCRIPTION OF THE DRAWINGS

FIG. 1 is a schematic flowchart of an embodiment of an off-the-production-line test method for a wireless communication BMS according to the present disclosure;
FIG. 2 is a schematic flowchart of another embodiment of an off-the-production-line test method for a wireless communication BMS according to the present disclosure;
FIG. 3 is a schematic flowchart of another embodiment of an off-the-production-line test method for a wireless communication BMS according to the present disclosure;
FIG. 4 is a schematic structural diagram of an embodiment of an off-the-production-line test apparatus for a wireless communication BMS according to the present disclosure;
FIG. 5 is a sequence diagram of information transmission of an off-the-production-line test system for a wireless communication BMS according to the present disclosure;
FIG. 6 is a schematic structural diagram of an embodiment of an off-the-production-line test device according to the present disclosure; and
FIG. 7 is a schematic structural diagram of an embodiment of an electronic information acquisition unit according to the present disclosure.

### DETAILED DESCRIPTION

The technical solutions in the embodiments of the present disclosure are clearly and completely described below with reference to the accompanying drawings in the embodiments of the present disclosure. Apparently, the described embodiments are merely some rather than all of the embodiments of the present disclosure. All other embodiments obtained by those of ordinary skill in the art based on the embodiments of the present disclosure without creative efforts should fall within the protection scope of the present disclosure.

### Embodiment 1

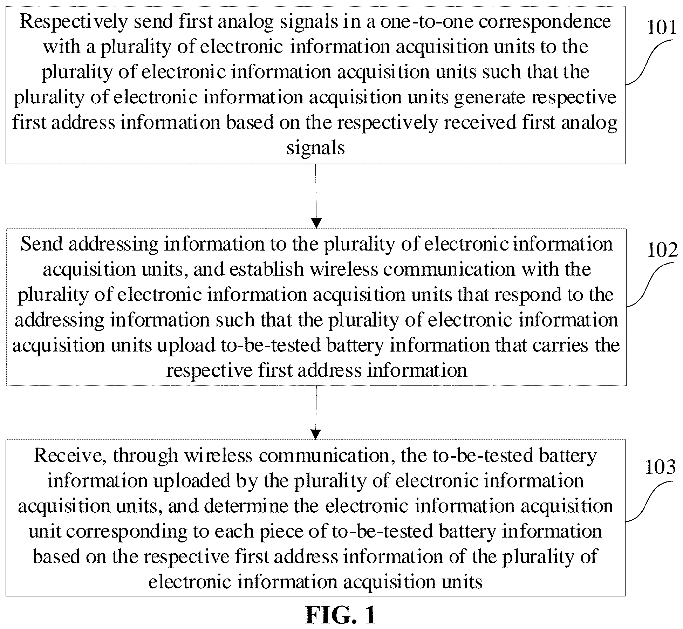

FIG. 1 is a schematic flowchart of an embodiment of an off-the-production-line test method for a wireless communication BMS according to the present disclosure, which mainly includes steps 101 to 103 and is specifically as follows:
Step 101: Respectively send first analog signals in a one-to-one correspondence with a plurality of electronic information acquisition units to the plurality of electronic information acquisition units such that the plurality of electronic information acquisition units generate respective first address information based on the respectively received first analog signals.

In this embodiment, the plurality of first analog signals are a plurality of analog signals with different voltages. After respectively receiving the first analog signals with different voltages, the plurality of electronic information acquisition units generate the respective first address information based on the respectively received first analog signals, such that different electronic information acquisition units have different first address information and are distinguished from each other.

In this embodiment, the electronic information acquisition unit may be an acquisition module configured to acquire battery information. The acquisition module is connected to a BMS through wireless communication, and acquires a voltage and temperature of a battery cell.

In this embodiment, the wireless communication may use a wireless communication protocol for CC2662R-Ql of Texas Instruments (TI).

In this embodiment, the plurality of electronic information acquisition units may be connected to each other through wireless communication.

Step 102: Send addressing information to the plurality of electronic information acquisition units, and establish wireless communication with the plurality of electronic information acquisition units that respond to the addressing information such that the plurality of electronic information acquisition units upload to-be-tested battery information that carries the respective first address information.

In this embodiment, after an off-the-production-line test apparatus for a wireless communication BMS establishes connections to the plurality of electronic information acquisition units through respective wireless communication modules, information is exchanged between them through addressing. The off-the-production-line test apparatus sends signals to the plurality of electronic information acquisition units. Only electronic information acquisition units with corresponding first address information respond. The responding electronic information acquisition units perform corresponding operations based on the signals sent by the off-the-production-line test apparatus.

Step 103: Receive, through wireless communication, the to-be-tested battery information uploaded by the plurality of electronic information acquisition units, and determine the electronic information acquisition unit corresponding to each piece of to-be-tested battery information based on the respective first address information of the plurality of electronic information acquisition units.

In this embodiment, the electronic information acquisition units acquire information related to a plurality of cells in a battery to be tested, such as voltages, temperatures, and the like of the battery cells. After acquiring the to-be-tested battery information, the electronic information acquisition units upload the to-be-tested battery information in response to instructions from the off-the-production-line test apparatus. The off-the-production-line test apparatus may display the to-be-tested battery information on a touchscreen interaction module.

In this embodiment, each piece of to-be-tested battery information includes specific first address information. The off-the-production-line test apparatus may identify the electronic information acquisition unit corresponding to each piece of to-be-tested battery information based on different first address information.

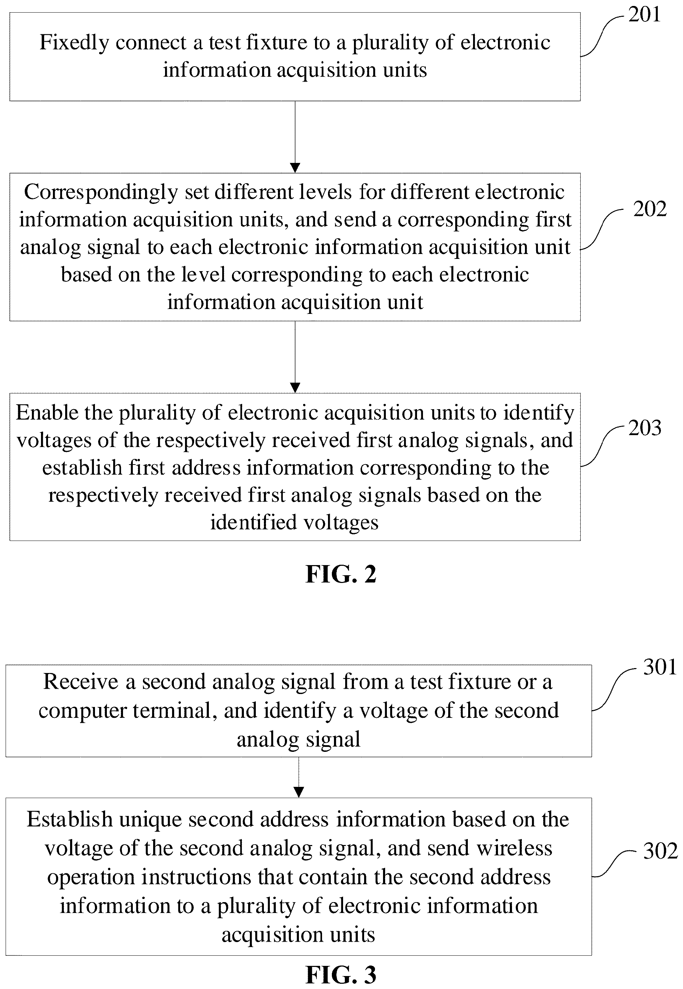

FIG. 2 is a schematic flowchart of another embodiment of an off-the-production-line test method for a wireless communication BMS according to the present disclosure, which mainly includes steps 201 to 203 and is specifically as follows:
In this embodiment, step 101 specifically includes steps 201 to 203.

Step 201: Fixedly connect a test fixture to the plurality of electronic information acquisition units.

In this embodiment, the test fixture is an electronic test fixture, for example, a ZF (ZF FRIEDRICHSHAFEN) electric vehicle test system or an in-circuit test (ICT) fixture, and is configured to test electronic devices such as electronic information acquisition units in a vehicle in terms of functions, service lives, performance, and the like.

In this embodiment, the fixed connection may be implemented through physical hardwiring. A communication enabling module of the off-the-production-line test apparatus is connected to address detection modules of the plurality of electronic information acquisition units such that the off-the-production-line test apparatus sends the first analog signals to the electronic information acquisition units.

Step 202: Correspondingly set different levels for different electronic information acquisition units, and send the corresponding first analog signal to each electronic information acquisition unit based on the level corresponding to each electronic information acquisition unit.

In this embodiment, correspondingly setting different levels for different electronic information acquisition units is specifically as follows: Adjust a resistance of an output pull-up resistor such that the output pull-up resistor and an input pull-down resistor of each electronic information acquisition unit connected to the output pull-up resistor are combined to obtain a corresponding level.

In this embodiment, the output pull-up resistor is disposed in the communication enabling module of the off-the-production-line test apparatus, and an interval between levels of the output pull-up resistor is a first preset resistance.

In the present disclosure, the first analog signal input to the electronic information acquisition unit is changed through the combination of the output pull-up resistor and the input pull-down resistor such that different first analog signals are input to different electronic information acquisition units, to establish mutually distinguishable first address information.

In this embodiment, sending the corresponding first analog signal to each electronic information acquisition unit based on the level corresponding to each electronic information acquisition unit is specifically as follows: Convert a rated working voltage into the plurality of first analog signals with different voltages based on the level corresponding to each electronic information acquisition unit; and respectively send the corresponding first analog signals for the corresponding levels to the plurality of electronic information acquisition units based on a preset sending sequence.

In the present disclosure, different levels are set to convert the working voltage into the first analog signals with different voltages.

In this embodiment, the pull-up resistor and the pull-down resistor convert the working voltage through voltage division. In this way, different electronic information acquisition units receive the first analog signals with different voltages at different levels, such that different electronic information acquisition units establish different first address information based on different first analog signals. For example, by default, the address detection module of the electronic information acquisition unit under test is configured to detect the input analog signal with the pull-down resistor to ground. The communication enabling module of the off-the-production-line test apparatus for a wireless communication BMS configures the pull-up resistor to pull up a level to a power supply voltage. The working voltage and resistance may be adjusted based on an actual test requirement. For example, it is assumed that the working voltage is 5.0 V, and a resistance of the input pull-down resistor in the address detection module of the wireless communication electronic information acquisition unit under test is 10K. By default, there are 10 levels. Levels of the output pull-up resistor in the communication enabling module of the off-the-production-line test apparatus may be set to 1K to 10K at an interval of 1K. Simultaneous use of 10 off-the-production-line test apparatuses for a wireless communication BMS can be ensured. Each off-the-production-line test apparatus for a wireless communication BMS can simultaneously monitor and measure 10 electronic information acquisition units connected thereto.

In the present disclosure, fixed physical connections to different electronic information acquisition units are implemented through the test fixture, and different first analog signals are sent to different electronic information acquisition units through level setting such that the electronic information acquisition units establish the respective first address information based on the first analog signals, to identify data sources and determine positions of the electronic information acquisition units during test data transmission.

In this embodiment, the plurality of electronic information acquisition units generate the respective first address information specifically includes step 203.

Step 203: Enable the plurality of electronic information acquisition units to identify voltages of the respectively received first analog signals, and establish the first address information corresponding to the respectively received first analog signals based on the identified voltages.

In this embodiment, after establishing the first address information corresponding to the respectively received first analog signals, the method includes: Store the first address information of the electronic information acquisition unit by the electronic information acquisition unit; and when the voltage of the first analog signal received by an electronic information acquisition unit is 0 V, clear the first address information stored by the electronic information acquisition unit. To facilitate re-pairing of each electronic information acquisition unit with the off-the-production-line test apparatus during a next test, the electronic information acquisition unit deletes the stored first address information after receiving the first analog signal with a voltage of 0 V.

In this embodiment, the first address information is two-bit address information.

In the present disclosure, the electronic information acquisition units establish mutually different first address information based on the received first analog signals, to prevent crosstalk during wireless communication connections to a test device or the test apparatus.

FIG. 3 is a schematic flowchart of another embodiment of an off-the-production-line test method for a wireless communication BMS according to the present disclosure, which mainly includes steps 301 and 302 and is specifically as follows:
Step 301: Receive a second analog signal from a test fixture or a computer terminal, and identify a voltage of the second analog signal.

In this embodiment, the second analog signal is set by a tester as needed.

In this embodiment, the tester may send second analog signals with different voltages to different off-the-production-line test apparatuses through test fixtures, such that different test fixtures establish different second address information based on different second analog signals.

Step 302: Establish unique second address information based on the voltage of the second analog signal, and send wireless operation instructions that contain the second address information to the plurality of electronic information acquisition units.

In this embodiment, different off-the-production-line test apparatuses have different second address information, to establish wireless communication connections between a plurality of off-the-production-line test apparatuses and different electronic information acquisition modules, and prevent crosstalk between different off-the-production-line test apparatuses.

In the present disclosure, when electronic information acquisition modules perform addressing, the test apparatus or the test device also performs addressing based on the second analog signal such that its second address information is distinguished from address information of another test apparatus, to prevent crosstalk when a plurality of test apparatuses are simultaneously used.

Further, after receiving, through wireless communication, the to-be-tested battery information uploaded by the plurality of electronic information acquisition units, and determining the electronic information acquisition unit corresponding to each piece of to-be-tested battery information based on the respective first address information of the plurality of electronic information acquisition units, the method includes:
The to-be-tested battery information includes battery cell voltage information and battery cell temperature information.

Perform data comparison on the battery cell voltage information and the battery cell temperature information based on actual operating parameters of a battery cell, determine whether the electronic information acquisition unit corresponding to the to-be-tested battery information is abnormal, and upload a determining result obtained through the data comparison to a cloud MES of a production department.

In this embodiment, the off-the-production-line test apparatus not only acquires the to-be-tested battery information uploaded by the electronic information acquisition units, but also compares acquired battery cell information with current battery cell voltage information and current battery cell temperature information in each piece of to-be-tested battery information. The current battery cell voltage information and the current battery cell temperature information come from a wireless communication BMS. When an error result of data comparison on the battery cell voltage information and/or the battery cell temperature information in any piece of to-be-tested battery information is greater than a first preset value, the electronic information acquisition unit corresponding to the to-be-tested battery information is abnormal. The determining result is transmitted to the cloud MES through a general packet radio service (GPRS) module of the off-the-production-line test apparatus for management.

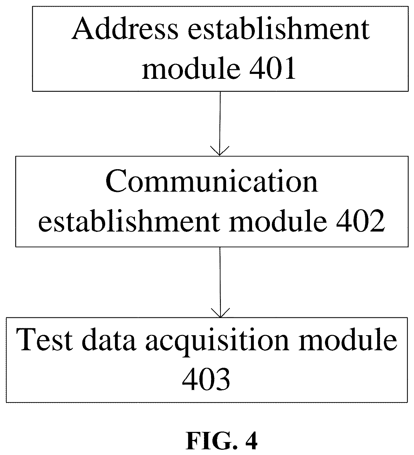

FIG. 4 is a schematic structural diagram of an embodiment of an off-the-production-line test apparatus for a wireless communication BMS according to the present disclosure, which mainly includes an address establishment module 401, a communication establishment module 402, and a test data acquisition module 403.

In this embodiment, the address establishment module 401 is configured to respectively send first analog signals in a one-to-one correspondence with a plurality of electronic information acquisition units to the plurality of electronic information acquisition units such that the plurality of electronic information acquisition units generate respective first address information based on the respectively received first analog signals.

In this embodiment, the address establishment module 401 includes a hardwired connection unit, a level setting unit, and an address establishment unit. The hardwired connection unit is configured to fixedly connect a test fixture to the plurality of electronic information acquisition units. The level setting unit is configured to correspondingly set different levels for different electronic information acquisition units, and send the corresponding first analog signal to each electronic information acquisition unit based on the level corresponding to each electronic information acquisition unit. The address establishment unit is configured to enable the plurality of electronic information acquisition units to identify voltages of the respectively received first analog signals, and establish the first address information corresponding to the respectively received first analog signals based on the identified voltages.

In this embodiment, the following modules operating concurrently with the address establishment module 401 are further included: a signal setting module and a test apparatus address establishment module. The signal setting module is configured to receive a second analog signal from a test fixture or a computer terminal, and identify a voltage of the second analog signal. The test apparatus address establishment module is configured to establish unique second address information based on the voltage of the second analog signal, and send wireless operation instructions that contain the second address information to the plurality of electronic information acquisition units.

The communication establishment module 402 is configured to send addressing information to the plurality of electronic information acquisition units, and establish wireless communication with the plurality of electronic information acquisition units that respond to the addressing information such that the plurality of electronic information acquisition units upload to-be-tested battery information that carries the respective first address information.

The test data acquisition module 403 is configured to receive, through wireless communication, the to-be-tested battery information uploaded by the plurality of electronic information acquisition units, and determine the electronic information acquisition unit corresponding to each piece of to-be-tested battery information based on the respective first address information of the plurality of electronic information acquisition units.

In this embodiment, after the test data acquisition module 403, a data comparison module is further included. The to-be-tested battery information includes battery cell voltage information and battery cell temperature information. The data comparison module is configured to perform data comparison on the battery cell voltage information and the battery cell temperature information based on actual operating parameters of a battery cell, determine whether the electronic information acquisition unit corresponding to the to-be-tested battery information is abnormal, and upload a determining result obtained through the data comparison to a cloud MES of a production department.

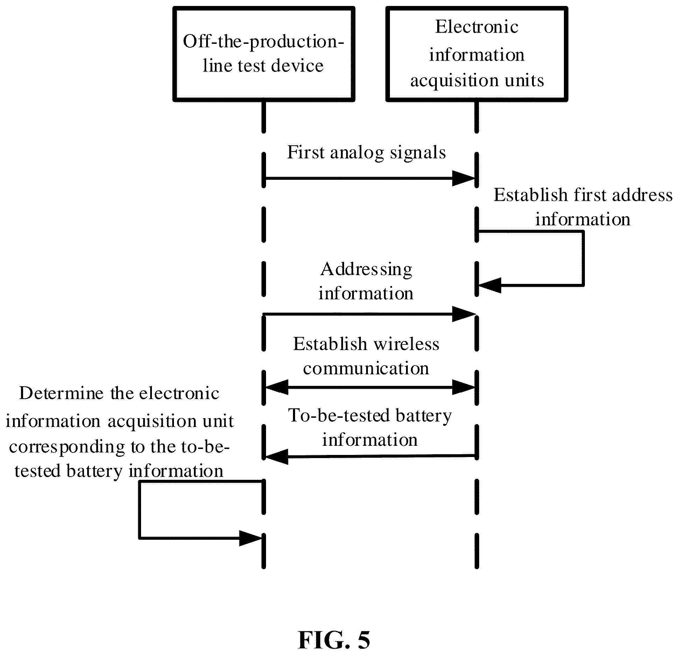

FIG. 5 is a sequence diagram of information transmission of an off-the-production-line test system for a wireless communication BMS according to the present disclosure. The off-the-production-line test system for a wireless communication BMS includes an off-the-production-line test device and a plurality of electronic information acquisition units.

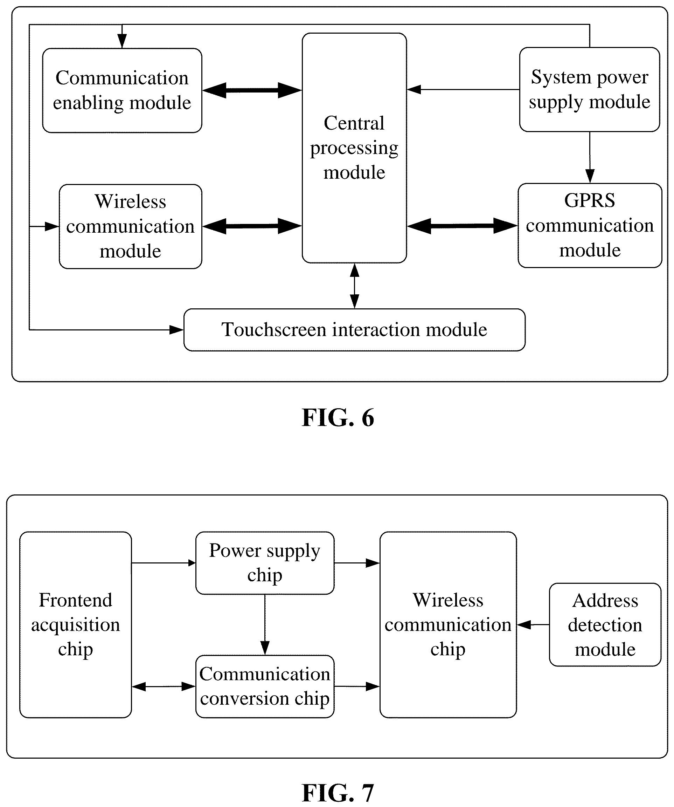

In this embodiment, the off-the-production-line test device is configured to perform the off-the-production-line test method for a wireless communication BMS according to any one of the embodiments of the present disclosure. FIG. 6 is a schematic structural diagram of an embodiment of the off-the-production-line test device according to the present disclosure. The off-the-production-line test device includes a communication enabling module configured to send first analog signals to the plurality of electronic information acquisition units and receive first address information uploaded by the plurality of electronic information acquisition units.

In this embodiment, the off-the-production-line test device further includes a central processing module, a wireless communication module, a system power supply module, a GPRS communication module, and a touchscreen interaction module. The central processing module establishes bidirectional communication with the communication enabling module, the wireless communication module, the GPRS communication module, and the touchscreen interaction module. The system power supply module is used for power distribution and management of internal power sources for all modules of the off-the-production-line test apparatus. The wireless communication module is configured to establish wireless communication with wireless communication chips of the electronic information acquisition units. The GPRS communication module is configured to connect to a cloud MES of a production department to ensure accurate transmission of test data. The touchscreen interaction module is configured to input and display instructions for production testing and display to-be-tested battery information uploaded by the electronic information acquisition units, to complete work such as starting a test task, ending a test task, configuring parameters, and displaying information. The central processing module is used for mutual scheduling among various modules.

The plurality of electronic information acquisition units are configured to generate respective first address information after receiving a plurality of first analog signals in a one-to-one correspondence with the plurality of electronic information acquisition units; establish wireless communication connections to the off-the-production-line test device in response to addressing information from the off-the-production-line test device; and acquire to-be-tested battery information, and upload the to-be-tested battery information to the off-the-production-line test device through wireless communication. FIG. 7 is a schematic structural diagram of an embodiment of the electronic information acquisition unit according to the present disclosure. The electronic information acquisition unit includes an address detection module configured to identify a voltage of the first analog signal and generate first address information corresponding to the voltage of the first analog signal during an off-the-production-line test.

In this embodiment, the electronic information acquisition unit further includes a frontend acquisition chip, a power supply chip, a communication conversion chip, and a wireless communication chip. The frontend acquisition chip is configured to acquire a battery cell voltage and a battery cell temperature in a BMS. The power supply chip is configured to supply power to the communication conversion chip and the frontend acquisition chip. The wireless communication chip is configured to establish wireless communication with a wireless communication unit of the off-the-production-line test apparatus. The communication conversion chip is used for interconnection between the plurality of electronic information acquisition units.

In the present disclosure, the corresponding first analog signals are sent to the electronic information acquisition units through hardware connections. Different electronic information acquisition units establish different first address information based on different first analog signals. In this way, each electronic information acquisition unit establishes wireless communication with the test apparatus through its unique first address information, and sends the to-be-tested battery information through wireless communication to complete testing. This prevents crosstalk problems that a position of the electronic information acquisition unit cannot be determined and a source of the to-be-tested battery information cannot be distinguished when the test apparatus tests a plurality of electronic information acquisition units.

The objectives, technical solutions, and beneficial effects of the present disclosure are further described in detail through the foregoing specific embodiments. It should be understood that the foregoing are merely specific embodiments of the present disclosure, but are not intended to limit the protection scope of the present disclosure. It should be particularly noted that any modifications, equivalent substitutions, improvements, and the like made by those skilled in the art within the spirit and principle of the present disclosure should be included within the protection scope of the present disclosure.

## Claims

1. An off-the-production-line test method for a wireless communication battery management system, BMS, comprising:
respectively sending first analog signals in a one-to-one correspondence with a plurality of electronic information acquisition units to the plurality of electronic information acquisition units, whereby the plurality of electronic information acquisition units generate respective first address information based on the respectively received first analog signals;
sending addressing information to the plurality of electronic information acquisition units, and establishing wireless communication with the plurality of electronic information acquisition units that respond to the addressing information, whereby the plurality of electronic information acquisition units upload to-be-tested battery information that carries the respective first address information; and
receiving, through wireless communication, the to-be-tested battery information uploaded by the plurality of electronic information acquisition units, and determining the electronic information acquisition unit corresponding to each piece of to-be-tested battery information based on the respective first address information of the plurality of electronic information acquisition units.

2. The off-the-production-line test method for a wireless communication BMS according to claim 1, wherein the respectively sending first analog signals in a one-to-one correspondence with a plurality of electronic information acquisition units to the plurality of electronic information acquisition units is as follows:
fixedly connecting a test fixture to the plurality of electronic information acquisition units; and
correspondingly setting different levels for different electronic information acquisition units, and sending the corresponding first analog signal to each electronic information acquisition unit based on the level corresponding to each electronic information acquisition unit.

3. The off-the-production-line test method for a wireless communication BMS according to claim 2, wherein the correspondingly setting different levels for different electronic information acquisition units is as follows:
adjusting a resistance of an output pull-up resistor, whereby the output pull-up resistor and an input pull-down resistor of each electronic information acquisition unit connected to the output pull-up resistor are combined to obtain a corresponding level.

4. The off-the-production-line test method for a wireless communication BMS according to claim 2, wherein the sending the corresponding first analog signal to each electronic information acquisition unit based on the level corresponding to each electronic information acquisition unit is as follows:
converting a rated working voltage into the plurality of first analog signals with different voltages based on the level corresponding to each electronic information acquisition unit; and
respectively sending the corresponding first analog signals for the corresponding levels to the plurality of electronic information acquisition units based on a preset sending sequence.

5. The off-the-production-line test method for a wireless communication BMS according to claim 1, wherein the plurality of electronic information acquisition units generate the respective first address information is as follows:
the plurality of electronic information acquisition units identify voltages of the respectively received first analog signals, and establish the first address information corresponding to the respectively received first analog signals based on the identified voltages.

6. The off-the-production-line test method for a wireless communication BMS according to claim 5, after establishing the first address information corresponding to the respectively received first analog signals, comprising:
respectively storing, by the electronic information acquisition units, the first address information of the electronic information acquisition units; and
when the voltage of the first analog signal received by an electronic information acquisition unit is 0 V, clearing the first address information stored by the electronic information acquisition unit.

7. The off-the-production-line test method for a wireless communication BMS according to any one of claims 1-6, when respectively sending the first analog signals in a one-to-one correspondence with the plurality of electronic information acquisition units to the plurality of electronic information acquisition units, comprising:
receiving a second analog signal from a test fixture or a computer terminal, and identifying a voltage of the second analog signal; and
establishing unique second address information based on the voltage of the second analog signal, and sending wireless operation instructions that contain the second address information to the plurality of electronic information acquisition units.

8. The off-the-production-line test method for a wireless communication BMS according to any one of claims 1-6, wherein the to-be-tested battery information comprises battery cell voltage information and battery cell temperature information;
after receiving, through wireless communication, the to-be-tested battery information uploaded by the plurality of electronic information acquisition units, and determining the electronic information acquisition unit corresponding to each piece of to-be-tested battery information based on the respective first address information of the plurality of electronic information acquisition units, the method comprises:
performing data comparison on the battery cell voltage information and the battery cell temperature information based on actual operating parameters of a battery cell, determining whether the electronic information acquisition unit corresponding to the to-be-tested battery information is abnormal, and uploading a determining result obtained through the data comparison to a cloud manufacturing execution system, MES, of a production department.

9. An off-the-production-line test apparatus for a wireless communication battery management system, BMS, comprising: an address establishment module, a communication establishment module, and a test data acquisition module; wherein
the address establishment module is configured to respectively send first analog signals in a one-to-one correspondence with a plurality of electronic information acquisition units to the plurality of electronic information acquisition units, whereby the plurality of electronic information acquisition units generate respective first address information based on the respectively received first analog signals;
the communication establishment module is configured to send addressing information to the plurality of electronic information acquisition units, and establish wireless communication with the plurality of electronic information acquisition units that respond to the addressing information, whereby the plurality of electronic information acquisition units upload to-be-tested battery information that carries the respective first address information; and
the test data acquisition module is configured to receive, through wireless communication, the to-be-tested battery information uploaded by the plurality of electronic information acquisition units, and determine the electronic information acquisition unit corresponding to each piece of to-be-tested battery information based on the respective first address information of the plurality of electronic information acquisition units.

10. An off-the-production-line test system for a wireless communication battery management system, BMS, comprising: an off-the-production-line test device and a plurality of electronic information acquisition units; wherein
the off-the-production-line test device is configured to perform the off-the-production-line test method for a wireless communication BMS according to any one of claims 1-8; and the off-the-production-line test device comprises a communication enabling module configured to send first analog signals to the plurality of electronic information acquisition units and receive first address information uploaded by the plurality of electronic information acquisition units; and
the plurality of electronic information acquisition units are configured to generate the first address information corresponding to the respectively received first analog signals after receiving the first analog signals in a one-to-one correspondence with the plurality of electronic information acquisition units, establish wireless communication connections to the off-the-production-line test device in response to addressing information from the off-the-production-line test device, acquire to-be-tested battery information, and upload the to-be-tested battery information to the off-the-production-line test device through wireless communication; and the electronic information acquisition unit comprises an address detection module configured to identify a voltage of the first analog signal and generate first address information corresponding to the voltage of the first analog signal during an off-the-production-line test.
